Europäisches Patentamt

European Patent Office

Office européen des brevets

(19)

(11) **EP 1 471 413 A1**

(12) **EUROPEAN PATENT APPLICATION**

(43) Date of publication:
   **27.10.2004 Bulletin 2004/44**

(51) Int Cl.7: **G06F 3/033**

(21) Application number: **03016330.7**

(22) Date of filing: **18.07.2003**

(84) Designated Contracting States:
   **AT BE BG CH CY CZ DE DK EE ES FI FR GB GR
   HU IE IT LI LU MC NL PT RO SE SI SK TR**
   Designated Extension States:
   **AL LT LV MK**

(71) Applicant: **SIEMENS AKTIENGESELLSCHAFT
   80333 München (DE)**

(72) Inventors:
   • **Hoeyer, Michael
     9200 Aalborg SV (DK)**
   • **Santa Cruz, Carmen
     9000 Aalborg (DK)**

(54) **Input device and portable electronic device**

(57)   An input device (10) comprises a plurality of means (101, 103) for detecting ambient light, adapted to generate a measurable signal in response to a light intensity; and a signal detecting means (201) for receiving said measurable signal from at least one of the means (101, 103) for detecting ambient light. The signal detecting means (201) is adapted to generate a user input in response to shadowing of at least one of said light sensing means (101, 103).

FIG 1

EP 1 471 413 A1

# FIG 2   I-I

**Description**

The invention generally relates to input devices, and more specifically to input devices using light intensity detection means.

The breakthrough of portable electronic devices in the last decades has lead to more sophisticated design requirements. The increased capabilities of many portable electronic devices and the still ongoing miniaturization together pose great challenges particularly for the design of such devices, especially when the devices should comprise any means for receiving user input. Traditionally, such means include one or multiple keys for navigation, joysticks, or trackball-like solutions. Some new portable electronic devices, such as mobile terminals, include a large color display and a menu-driven operating system, thus enhancing the possibilities available for using user input, thereby giving new lines of thought for a design engineer.

The placement and size of the controls for menu navigation is a determinant factor for the usability of a mobile device. The navigation keys or joystick need a large surface area on the front side of the device, which can be viewed as a drawback, because the area used by them could otherwise be used for other purposes, such as for an even larger display.

Current solutions for navigation in the menu structure require either multiple pressing of different keys, or tilting of a joystick into different directions. Due to the size of available surface, and the reasons relating to the size of the display discussed above, the best placement for an input device suitable for navigating in the menu would the back cover of the device. Prior art solutions do not ergonomically apt well enough for that, because of the obvious uncomfort: giving user input either requires relatively large forces or movements in the long run tiresome for the wrist or fingers.

It is an object of the present invention to bring about a novel input device which does not continuously necessitate ergonomically adverse wrist and/or finger movements, especially exerting pressure, for example in such situations where the input device would be used for simple navigation in a menu structure. Because the input device is adapted to use the principle of detecting a change in ambient light intensity at a means for detecting ambient light, there is no need to use a separate light source as opposed to some state-of-the-art optical input devices.

A further object of the present invention is to bring about a novel portable electronic device wherein such a novel input device is used.

The objects of the invention can be achieved in the manner as described in any one of the independent patent claims. The dependent patent claims describe various advantageous embodiments of the present invention.

A further advantage of the different embodiments of the present invention is its constructional simplicity. The input device and the portable electronic device according to the invention do not necessarily include any moving parts, therefore making the input device and the portable electronic device particularly resistant towards mechanical wear and tear.

The means for detecting ambient light can further be positioned close to light pipes. This makes it easier to design an aesthetically more pleasant input device or portable electronic device, because then the means for detecting ambient light do not need to be on top of said devices but may be inside the device, when the light pipes conduct ambient light to the means for detecting ambient light. Further, in order to increase the light intensity in the detecting means, the light pipe or the light detecting means can include a cap having a curved surface.

According to one further embodiment of the present invention, at least one means from the plurality of means for detecting ambient light is surrounded by a protruding annular element. This annular element has two advantageous functions: firstly, it enhances the shadowing caused by the user's finger. Secondly, it helps the user to sense when he or she is shadowing the detecting means well enough.

In the following, the preferred embodiments of the present invention are described in more detail with help of the examples shown in the accompanying drawings 1 to 9B, of which:

Figure 1 shows an input device 10 comprising a plurality of means 101, 103 for detecting ambient light;

Figure 2 shows a signal detecting means 201 for receiving a measurable signal from at least one of the means 101 or 103 for detecting ambient light;

Figures 3A, 3B, and 3C illustrate schematically different constructional possibilities for the means 101 for detecting ambient light and signal detecting means 201;

Figures 3D and 3E illustrate two further possibilities for placing the lenses 303B and 303C for increasing the light flux at the means 101 for detecting ambient light;

Figures 4A and 4B show a top view and a cross-sectional cut of the protruding annular element 401;

Figure 5 shows an input device 10 including a means 501 for sensing pressure;

Figure 6 is a portable electronic device including an input device according to the present invention;

Figure 7 is a diagram showing some blocks used in a portable electronic device used to deduce the value of user input;

Figures 8A, 8B, and 8C illustrate some possible shadowing patterns for an annular and a matrix-like configuration of the input device; and

Figures 9A and 9B illustrate further two shadowing patterns of the input device.

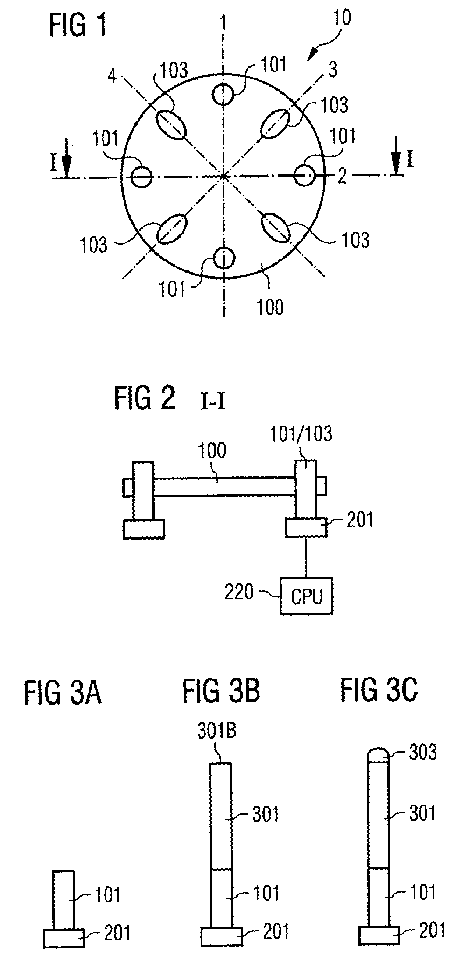

Same reference numerals correspond to similar structural elements throughout Figures 1 to 9B.

Figure 1 shows an input device 10 comprising a plurality of means 101, 103 for detecting ambient light, each adapted to generate a measurable signal in response to a light intensity. Between the means 101, 103 for detecting ambient light there is the housing 100 of the input device 10. The housing 100 is preferably molded plastics.

Means 101, 103 for detecting ambient light is an electrical device that responds to a change in the intensity of the light falling upon it. It typically comprises a phototransistor, a photocell, or a photodiode. The phototransistor has been a widely used optical sensor, because it offers a better trade-off between light sensitivity and response speed as compared with other sensors. Photocells are used in many ambient light detection applications. Photodiodes are also used for applications requiring either extremely fast response time or linear response over several magnitudes of change of light level. Even though in the following it is assumed that a photocell is used, the other means, in particular a phototransistor or a photodiode, would be suitable for the same purpose.

The electrical characteristics of a photocell change when light is incident upon it. The most common type of photocell comprises two electrodes separated by a light-sensitive semiconductor material. A voltage source connected to the electrodes sets up a current even in the absence of light. When light strikes the semiconductor section, the currrent in the circuit increases in proportion to the intensity of the light.

A photovoltaic type of photoelectric cell generates and supports an electric current without being attached to any external voltage source, when the photoelectric cell is exposed to light. The cell usually comprises a semiconductor crystal with two zones composed of dissimilar materials. When the crystal is exposed to light, a voltage is set up across the junction.

A phototransistor can generate a small current acting like the input current in a conventional transistor and thus controls a larger current in the output circuit.

As shown in Figure 2 corresponding a cross-section in direction I-I marked in Figure 1, the input device 10 further comprises a signal detecting means 201 electrically connected to said means 101, 103 for detecting ambient light to receive a measurable signal from at least one of them. According to the present invention, said signal detecting means 201 are adapted to generate a user input in response to shadowing of at least one of said means 101, 103 for detecting ambient light. Further, the signal detecting means 201 is further functionally connected to a microprocessor 220. The microprocessor 220 analyzes the output of the signal detecting means 201.

The input device 10 works so that the user gives input by shadowing one or more of means 101, 103 for detecting ambient light. The effect of the shadowing is that there will be no flux at all or only a significantly smaller flux than otherwise of ambient light reaching the means 101, 103 for detecting ambient light.

When photons from ambient light are absorbed, their energy is transferred to the extra electrons in the negatieve pole, causing them to flow to the positive pole thus creating new holes that start flowing to the negative pole. The current caused in this manner can then be detected. Photovoltaic cells generate a voltage when light falls on them. They are inexpensive and simple to assembly and they do not require even a power supply. Because the output of a photocell is fairly linear with light intensity, it is possible to calibrate it in a straightforward manner. Therefore it apts well for mass production.

In response to a change in the flux, the signal detecting means 201 then propagate a signal to the microprocessor 220 which evaluates the signal.

The microprocessor 220 receives signals deriving from all signal detecting means 201 and it is adapted to periodically read signals $S_1$, $S_2$, $S_3$, ..., $S_k$. k denotes here the number of means 101, 103 for receiving ambient light.

In evaluating the $i^{th}$ signal $S_i$, the microprocessor 220 compares at moment $t_k$ the output $V_{i,\,k}$ of the signal detecting means 201 with the output $V_{i,\,k-1}$ detected earlier at moment $t_{k-1}$. The time difference $|t_k - t_{k-1}|$ can be some microseconds depending on the microprocessor 220 and the reaction time of the signal detecting means 201, but it is desirable to have it shorter, in the region of less than 100 or 10 μs, in order to ensure enough processing time for the operations to be launched in response to detecting user input. Examples of such operations include updating the display, loading different programs into memory of the portable electronic device, and so forth. If the delay between user giving his or her input and the input device 10 receiving the user input can be kept reasonably short, the impression that the portable electronic device is working in real time is stronger. This is a crucial feature especially if the input device 10 is used for providing user input in programs requiring extremely short and precise user input, such as games or surgical applications.

If the result of the detection shows that the output $V_{i,k}$ of the signal detecting means 201 has decreased from the output $V_{i,\,k-1}$ detected earlier more than a predefined threshhold ε, i.e. difference $\Delta_i = V_{i,\,k} - V_{i,k-1} > \varepsilon$, then the microprocessor compares the differences $\Delta_j = V_{j,k} - V_{j,\,k-1}$ for all other signals $S_j$ (j=1, 2, 3, ..., n; j ≠ i) from the outputs of signal detecting means 201 connected to other means 101, 103 for detecting

ambient light. If $\Delta_j > \varepsilon$ for at least two different values of j, then it can be deduced that the intensity of the ambient light has suddenly decreased and that there is no real user input given at the moment. The sudden decrease mathematically means that the time rate of the intensity exceeds a predefined negative value, i.e.

$$\Delta_j / (t_i - t_{i-1}) > - |\delta|,$$

where $t_i$ and $t_{i-1}$ are two instances of time where measurements are made.

Instead of using the time rate of the intensity, the values of the results derived from the signal detection means 201 can be used. In this case values obtained from different means 101, 103 for detecting ambient light are compared with each other, and the shadowed key is then selected among those ones showing the smallest flux.

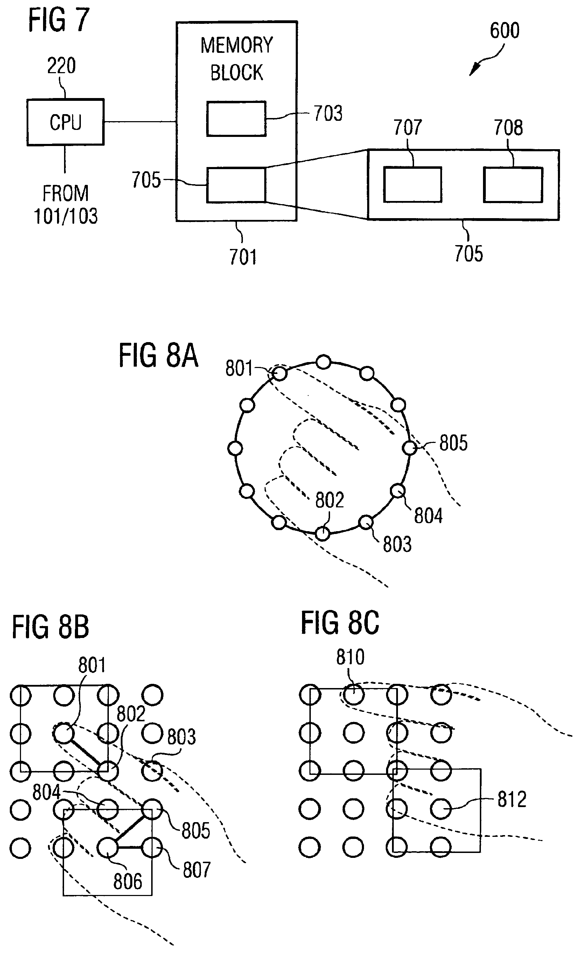

The method of estimating the value of the user input will be described in more detail below with reference to Figures 7, 8A-8C, and 9A-9B.

If the means 101, 103 for detecting light are different from each others, or, as shown in Figures 3A to 3C, there are different configurations for each key present, then the predefined threshhold $\varepsilon$ can be uniquely defined for each means or group of means 101, 103 for detecting ambient light, possibly defined by the type of the means. For this purpose, these types or different configurations can be programmed to be available for the microprocessor 220. Further, the input device 10 can comprise sensors which lead to automatic type detection ("classmark principle") of the means 101, 103 for detecting ambient light. For example, the sensitivity or shape can be changed, so that the user can use his preferred shadowing pattern, such as putting his or her finger or hand very close to the means 101, 103 for detecting ambient light, or keeping it further away from it.

As can be seen from Figure 1, the means 101 for detecting ambient light, together with their corresponding signal detecting means 201 (not shown) are located on either axes 1 and 2. The input device 10 can be made suitable for navigation in a menu "up/down" or "left/right" -manner even when there are only two means 101 for detecting ambient light and corresponding signal detecting means 201. However, the input device becomes more cursor-like when there are both axes 1 or 2 present. Then the means 101 for detecting ambient light and corresponding signal detecting means can be positioned symmetrically along the axes 1 and 2. If more input directions are desired, then more means 103 for detecting ambient light, as well as corresponding signal detecting means 201 (not shown) can be added along selected axes 3 and 4. The example of Figure 1 shows only four symmetry axes (or mirror symmetry around axis 2), but in principle there are no limitations in that how many axes can be implemented, if means 101, 103 for detecting ambient light and signal detecting means 201 are suitably selected.

Figure 3A shows the simplest construction for means 101 for detecting ambient light and signal detecting means 201. The means 101 for detecting ambient light are positioned directly on the signal detecting means 201. The means 101 for detecting ambient light can include photovoltaic material. Then they provide a voltage to the signal detecting means 201 responsively to exposure for ambient light. The signal detecting means 201, such as an analog-to-digital coverter, then transforms the output of means 101 for detecting ambient light to a form suitable for processing with a microprocessor 220.

Figure 3B shows another constructional possibility for means 101 for detecting ambient light and signal detecting means 201. Now the means 101 for detecting ambient light are located between a light pipe 301 and signal detecting means 201. The light pipe 301 captures photons and transfers them to the means 101 for detecting ambient light. In this way, the means 101 for detecting ambient light can be placed deeper, i.e. further away from the top surface of the input device 10. This is important especially if the means 101 for detecting ambient light consist of material that is not very shock resistant. Further, such a construction helps in keeping the means 101 for detecting ambient light clean from being soiled or getting dusty. The light pipe 301 may be hollow or full, and the end 301B is preferably closed.

Figure 3C shows the construction of Figure 3B further enhanced by that there is a cap 303 having a curved surface on the top of the light pipe 301. The purpose of the cap 303 is to capture more ambient light which is then led with help of total internal reflection to the light pipe 301 and to the means 101 for detecting ambient light.

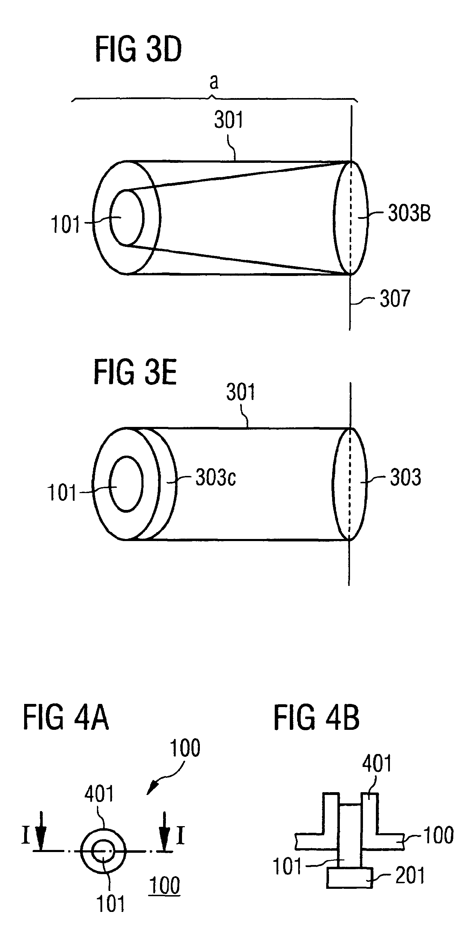

In Figure 3D a lense 303B covers the optical pipe 301 which has been assembled to penetrate inside of the surface 307 of the housing. The lense 303B is preferably convex so that it focuses a maximal amount of ambient light to a distance a from the optical axis of the lense 303B which can be parallel to the surface 307 of the housing. At distance a from the optical axis of the lens 303B there is the sensing means 101 for detecting ambient light. The effect of the lense 303B is to increase the flux of ambient light at the sensing means 101 for detecting ambient light.

Figure 3E shows another possibility for placing the lense. Now the optical pipe 301 is covered by a cap like in Figure 3C, and in order to increase the flux at the sensing means 101 for detecting ambient light, there is a lense 303C in front of the lense 101. Now because the lense 303C is very close to the sensing means 101 for detecting ambient light, the lense 303C is more convex than in the example shown in Figure 3D.

Even though the examples in Figures 3A to 3C and 4A to 4B show only means 101 for detecting ambient light, it is analogous to have similar solutions also for means 103 for detecting ambient light.

Figure 4A shows a top view of a protruding annular element 401 around a means 101 for detecting ambient light. Were another constructional possibility, such as that of Figure 3A or 3B chosen, the protruding annular element 401 could be located around a light pipe 301, or around a cap 303. The purpose of the protruding annular element 401 is to enhance the shadowing caused by the user's finger. Further, it helps the user to sense when he or she is shadowing the detecting means well enough. It also protects the light detecting means 101, light pipe 301, or cap 303 from external shocks.

Figure 4B shows a cross-section of the protruding annular element 401. It extends from the housing 100. The easiest way to construct the protruding annular element 401 is to design it already to the mold if the housing is of plastic mould. Another way to construct it is to use a sealing ring instead. Especially suitable materials are rubber or silicon. Also other variants are possible, depending on the desired design for the feel'n look. If the housing 100 were of wood, then even metal rings would do.

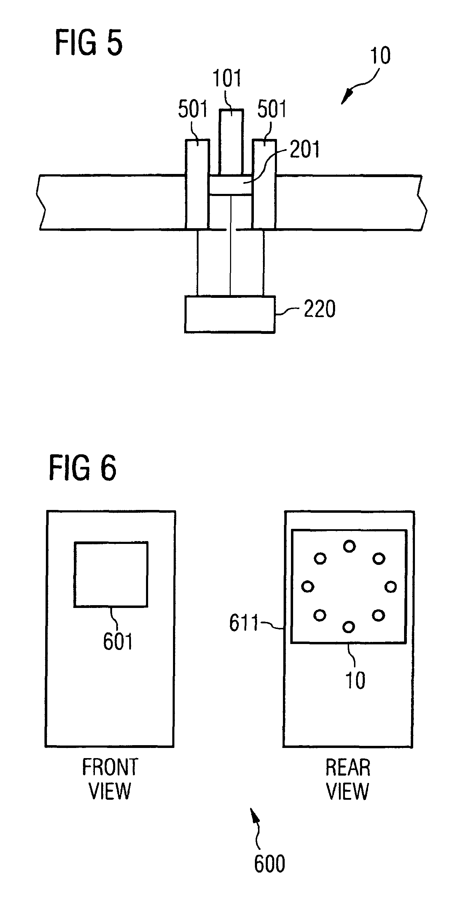

Figure 5 shows a further embodiment of the present invention. The input device 10 now includes a means 501 for sensing pressure which can have an annular shape to fit instead of using a molded protruding annular element. The means 501 for sensing pressure can be of any conventional type, i.e. it can also be made of a compressible material. Some new materials, such as piezoelectric or piezoresistive materials can also be used. Depending on the solution for the means 501 for sensing pressure used, the output of the pressure sensor 501 is fed either directly to the microprocessor 220, or analog-to-digital converted in an analog-to-digital converter (not shown) first.

The means 101, 103 for detecting ambient light are arranged for main directions (1 and 2 in Figure 1) of a directional input device 10, Then the input device can easily be used for obtaining user input in the main directions (corresponding X and Y directions on a display of a portable electronic device). In such a case, by using means 501 for sensing pressure, the input device 10 can be used for obtaining input in a direction normal to a surface defined by the direction vectors. If the unit vectors were i and j, then the input describing the magnitude of the pressure exerted on the means 501 for sensing pressure would correspond to the amount with which the unit vector k in the Z direction should be multiplied. In this manner the input device 10 can be turned to a real 3D input device.

Figure 6 shows a front and rear views of a portable electronic device 600. On the front side, the portable electronic device 600 has a display 601. The input device 10 can be installed to a back cover 611 of said portable electronic device. In the example shown in Figure 6, the back cover 611 is exchangeable, therefore it being necessary to arrange a connector, such as a socket connector, between the input device 10 and the rest of the portable electronic device 600. An advantage of such a solution is that in this manner the portable electronic device 600 can be used with the inventive input device 10 in conditions where there is enough ambient light. In a relatively dark surroundings the user can then exchange the input device 10 to a conventional input device 10.

Figure 7 is a diagram showing some blocks used in a portable electronic device 600 used to deduce the value of user input. In addition to the blocks already described in Figure 2, the portable electronic device includes a memory block 701. The microprocessor 220 can access the the memory block 701 and read data stored therein. In the memory block 701 there is a pattern recognition block 703 and input value library 705.

The input value library 705 comprises detected signal values 707 and model patterns 708.

The pattern recognition block 703 comprises code that is executable by the microprocessor 220. The pattern recognition block 703 compares detected signal values 707 with model patterns 708, and produces an input value when the detected signal values 707 matches with any of the model patterns 708. If the detected signal values 707 do not match with any of the model patterns 708, the pattern recognition block 703 either retries to recognize a user input, or sends a message to the microprocessor 220 for signalling to the user that the input was not successful. The signalling may involve making an audible signal via a loudspeaker or activating a visual sign by display or any input device led.

Figures 8A, 8B, and 8C illustrate some possible shadowing patterns for an annular and a matrix-like configuration of the input device.

Figure 8A shows a shadowing pattern which would result when the user is shadowing input key 801. The input key 801 as well as the other input keys 802, 803, 804, and 805 which are also shadowed comprise means 101 or 103 for detecting ambient light. Now the the shadow of hand covers a sequence of connected input keys 802, 803, 804, and 805. The model patterns 708 comprise also selection rules, and because there is only one isolated key (key 801), the value assigned to this single key is selected by the pattern recognition block 703.

Figure 8B is analogous to Figure 8A. Now the key which is shadowed is key 801. This means that also keys 802, 803, 804, 805, 806, and 807 are shadowed.

Figure 8C shows a shadowing pattern where the pattern recognition block 703 is unable to deduce which one of keys 810 and 812 is shadowed.

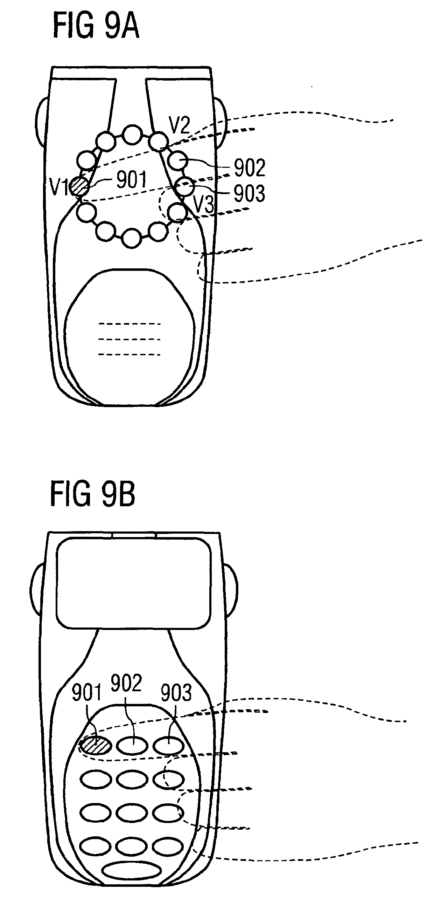

Figures 9A and 9B illustrate two further shadowing patterns of the input device. In Figure 9A the area of the surface of the keys is small. Therefore, a variation in intensity of ambient light due to changes in a distant light source (e.g. light bulb or sun) are more likely to affect all photosensors simultaneously.

In Figure 9A, the result $V_1$ derived from the out-

put of the light detecting means 101 or 103 in key 901 shows that the intensity of light ending up to the light detecting means 101 or 103 $V_1$ is considerably smaller than the detection results for keys 902 ($V_2$) or 903 ($V_3$), i.e. $V_1 << V_2, V_3$. The main reason for this is that the finger tip is much closer key 901 thus shadowing it better. On the contrary, the finger covers keys 902 and 903 in a less perfect manner. Similar considerations apply also for Figure 9B.

As already noted, the pattern recognition block 703 compares model patterns 708 with the detected signal values 707. For example, for a keyboard shown in Figure 9B where the keys are on the fron side of a portable electronic device, the selection rules in the pattern recognition block 703 preferably include any of the following:

Rule 1: If the user is right handed, the keys to be primarily selected are on the left side of the keyboard (for a left handed user just the opposite);

Rule 2: If the number of shadowed neighbor keys as far left than the leftmost key is greater than zero, no unique detection is possible; and

Rule 3: The key will be selected, for which the result derived from data obtained from signal detecting means 201 shows that the ambient light intensity is at lowest.

The initial values for the model patterns 708 are stored at the factory into the memory block 701. These initial values can be obtained by performing testing where a large number of test persons type in number sequences. The results of resulting shadowing patterns for these number sequences are evaluated and responsively to the evaluation step, the most common patterns are stored as model patterns 708. The system may be self-learning as well.

Although the invention was described above with reference to the examples shown in the appended drawings, it is obvious that the invention is not limited to these but may be modified by those skilled in the art without difference from the scope and the spirit of the invention.

**Claims**

1. An input device (10) comprising: a plurality of means (101, 103) for detecting ambient light, adapted to generate a measurable signal in response to a light intensity; and a signal detecting means (201) for receiving said measurable signal from at least one of the means (101, 103) for detecting ambient light; **characterized in that**: said signal detecting means (201) is adapted to generate a user input in response to shadowing of at least one of said light sensing means (101, 103).

2. An input device (10) according to claim 1, further comprising: light pipes (301) in front of at least one of said plurality of means (101, 103) for detecting ambient light.

3. An input device (10) according to claim 2, wherein: said light pipes (301) are closed from their outer end (301B).

4. An input device (10) according to claim 2 or 3, wherein: said light pipes (301) are covered by a cap (303) having a curved surface.

5. An input device (10) according to any one of the preceding claims, wherein: the means (101, 103) for detecting ambient light are arranged for main directions of a directional input device (10).

6. An input device (10) according to any one of the preceding claims, wherein: the means (101, 103) for detecting ambient light are arranged to an annular form.

7. An input device (10) according to any one of the preceding claims, further comprising: a protruding annular element (401) around at least one of said plurality of means (101, 103) for detecting ambient light, around a light pipe (301), or around a cap (303).

8. An input device (10) of claim 7, wherein: said protruding annular element (401) is replaced with means (501) for sensing pressure.

9. An input device (10) of claim 8, wherein: said means (501) for sensing pressure are adapted to produce an input value.

10. A portable electronic device (600), comprising: an input device (10) according to any one of claims 1 to 9.

11. A portable electronic device (600), comprising: an input device (10) according to claim 8 or 9, wherein: the means (101, 103) for detecting ambient light are used for obtaining an input direction in a surface (XY), and the means (501) for sensing pressure are used for obtaining an input signal in a direction (Z) normal to said surface.

12. A portable electronic device (600) of claim 10 or 11, wherein: the input device (10) is assembled to a back cover of said portable electronic device (600).

13. A portable electronic device (600) of claim 10, 11, or 12, wherein: the input device (10) is assembled into an exchangeable cover (611) of the portable electronic device (600).

**14.** A portable electronic device (600) of claim 10, 11, 12, or 13, further comprising: a pattern recognition block (703) adapted to compare detected signal values (707) derived from the signal detecting means (201) with model patterns (708) stored in a memory block (701), and to produce an input value in response to the comparison when the detected signal values (707) matches with any of the model patterns (708).

**15.** A portable electronic device (600) of claim 14, further comprising: means (703) for sending a message to a microprocessor (220) for signalling to the user that the input was not successful.

FIG 1

FIG 2   I-I

FIG 3A     FIG 3B     FIG 3C

## FIG 3D

## FIG 3E

## FIG 4A

## FIG 4B

FIG 5

FIG 6

FRONT
VIEW

REAR
VIEW

FIG 7

220

CPU

FROM
101/103

MEMORY
BLOCK

703

705

701

600

707

708

705

FIG 8A

801

805

802

804

803

FIG 8B

801

802

803

804

805

806

807

FIG 8C

810

812

FIG 9A

FIG 9B

**European Patent Office**

## EUROPEAN SEARCH REPORT

Application Number

EP 03 01 6330

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 4 937 443 A (SMOOT GEORGE W) 26 June 1990 (1990-06-26) | 1-3,10 | G06F3/033 |
| Y | * column 1, line 39 - line 45 * <br> * column 2, line 29 - line 68 * <br> * figures 1,2 * | 4 | |
| X | US 4 329 581 A (HELFRICH JR ROBERT C ET AL) 11 May 1982 (1982-05-11) <br> * figures 1-3 * <br> * column 2, line 2 - line 21 * <br> * column 3, line 25 - line 28 * | 1-3 | |
| Y | WO 99 30192 A (ANDERSON JAMES BURR ;WOODWARD RONALD O (US); YOUNG JOE P (US); HUL) 17 June 1999 (1999-06-17) <br> * page 35, last paragraph; figures 30-32 * | 4 | |
| A | US 5 668 367 A (WINTRICH FRANZ  ET AL) 16 September 1997 (1997-09-16) <br> * column 2, line 10 - line 12; figure 2 * | 4 | |

TECHNICAL FIELDS SEARCHED     (Int.Cl.7)

G06F

*The present search report has been drawn up for all claims*

| Place of search | Date of completion of the search | Examiner |
|---|---|---|
| BERLIN | 6 February 2004 | Griesbach, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                      EP 03 01 6330

This annex lists the patent family members relating to the patent documents cited in the above-mentioned European search report.
The members are as contained in the European Patent Office EDP file on
The European Patent Office is in no way liable for these particulars which are merely given for the purpose of information.

06-02-2004

| Patent document cited in search report | | Publication date | Patent family member(s) | | Publication date |
|---|---|---|---|---|---|
| US 4937443 | A | 26-06-1990 | CA | 2053314 A1 | 29-01-1991 |
| | | | EP | 0484445 A1 | 13-05-1992 |
| | | | JP | 5501182 T | 04-03-1993 |
| | | | WO | 9102268 A1 | 21-02-1991 |
| US 4329581 | A | 11-05-1982 | NONE | | |
| WO 9930192 | A | 17-06-1999 | US | 6168302 B1 | 02-01-2001 |
| | | | US | 6193399 B1 | 27-02-2001 |
| | | | US | 6238074 B1 | 29-05-2001 |
| | | | US | 6186650 B1 | 13-02-2001 |
| | | | US | 6260991 B1 | 17-07-2001 |
| | | | US | 6217201 B1 | 17-04-2001 |
| | | | US | 6244734 B1 | 12-06-2001 |
| | | | US | 6164805 A | 26-12-2000 |
| | | | AU | 2086099 A | 28-06-1999 |
| | | | EP | 1066172 A2 | 10-01-2001 |
| | | | US | 2002102058 A1 | 01-08-2002 |
| | | | WO | 9930192 A2 | 17-06-1999 |
| | | | US | 2001019488 A1 | 06-09-2001 |
| | | | US | 6139176 A | 31-10-2000 |
| US 5668367 | A | 16-09-1997 | DE | 4422414 A1 | 04-01-1996 |
| | | | CA | 2152892 A1 | 30-12-1995 |
| | | | EP | 0694771 A1 | 31-01-1996 |
| | | | US | RE36094 E | 16-02-1999 |
| | | | AT | 188032 T | 15-01-2000 |
| | | | DE | 69514051 D1 | 27-01-2000 |
| | | | DE | 69514051 T2 | 31-08-2000 |

EPO FORM P0459

For more details about this annex : see Official Journal of the European Patent Office, No. 12/82